# EUROPEAN PATENT APPLICATION

(11) **EP 4 722 751 A1**
(43) Date of publication of application: **08.04.2026**
(21) Application number: 24204436.0
(22) Date of filing: 03.10.2024
(51) Int. Cl.: G01R 33/38, G01R 33/3815, H01F 6/06, G01R 33/421

(54) **SUPERCONDUCTING COIL SUPPORT DEVICE ADAPTED TO IMPROVE SUPPORT STUCTURE STIFFNESS**

(71) Applicant: Koninklijke Philips N.V., 5656 AG Eindhoven (NL)
(72) Inventor: DILORENZO, Peter, Eindhoven (NL); HILDERBRAND, Joshua Kent, Eindhoven (NL)
(74) Representative: Philips Intellectual Property & Standards

(57) **Abstract**

A superconducting apparatus includes: an electrically superconductive coil having a first and second coil sections, which are separated and spaced apart from each other; a first support structure and a second support structure disposed to support the first and second coil sections. The first and second support structures are configured to maintain relative axial positions of the first and second coil sections to be fixed when the first and second coil sections are energized and de-energized, and to allow each of the first and second coil sections to expand radially during ramp energization; and a third support structure including a center ring or a mid-flexure stiffener, and a mid-flexure disposed between the first support structure and the second support structure. The center ring is adapted to provide a reactionary force to bending forces on the first and second coil sections and the mid-flexure structure is adapted to provide a substantially constant contact force with the first and second coil sections during expansion when the first and second coil sections are energized.

## Description

### BACKGROUND

Magnetic Resonance Imaging (MRI) devices comprise superconducting magnets used to generate the DC magnetic fields needed for MR imaging. Typical MR magnets comprise main coils and shield coils, with the main coils adapted to generate the main magnetic field and the shield coils adapted to shield the MRI device from stray fields often generated by gradient coils of the MRI device.

In operation, the magnetic resonance (MR) magnets generate Lorenz forces, which are typically radial forces. A coil consists of a plurality of windings of superconducting wire. The winding pattern of such a coil is a compromise of high fill factor, electrical insulation between windings, thermal conductivity of the combined material, and mechanical stability. Magnetic forces are directed so that individual windings repel each other when current is applied. These radial forces are exerted on the magnet structure and cause so-called hoop stresses. Hoop stress is proportional to magnetic field density, current density, and the radius of the coil. Often a technique known as overbanding is used, with wire layers of suitable material (e.g., stainless-steel) disposed around the coils of the superconducting magnet to provide a stabilizing force to the radial hoop stresses. These so-called hoop stresses can be so large that they damage the coil.

In addition to hoop stresses, known superconducting magnets are susceptible to reduced performance caused by heat, which can deleteriously impact their operation. In addition to ambient heat, eddy currents created by the gradient coils can add unwanted heat to the MR magnet.

Certain known MR devices include a continuous (e.g., cylindrical) support structure to mitigate the radial forces on the magnet when energizing (so-called ramping up) and once energized. These continuous support structures are more susceptible to the eddy currents from the gradient coils and ambient heat. To address these heating issues in structures comprising the continuous support structure, certain known MR devices use a so-called cooling bath, in which the superconducting coils are immersed in a cooling material such as helium to remove heat generated.

In other MR structures, discrete support structures are used. These discrete support structures reduce the impact of eddy currents and reduce the surface area of the support structure compared to continuous support structures. Such discrete structures are, for example, described in commonly owned U.S. Patent 10,365,338 to Jonas, et al., the entire disclosure of which is specifically incorporated herein by reference. While such discrete structures provide certain benefits, including the ability to avoid use of a cooling bath, issues with movement of the coils during ramp up and after energizing is complete due to radial forces on the coils, these known structures unfortunately often do not balance the forces sufficiently and may result in distortion of the coil shape. Such distortions can adversely impact the magnetic field generated by the superconducting coils, and ultimately may result in inaccuracies in the MR images generated by the MRI device.

What is needed, therefore, is a medical device that overcomes at least the noted drawbacks of the known approaches described above.

### SUMMARY

In accordance with a representative embodiment, a superconducting apparatus, comprises: an electrically superconductive coil having a first and second coil sections, which are separated and spaced apart from each other; a first support structure and a second support structure disposed to support the first and second coil sections, wherein the first and second support structures are configured to maintain relative axial positions of the first and second coil sections to be fixed when the first and second coil sections are energized and de-energized, and to allow each of the first and second coil sections to expand radially during ramp energization; and a third support structure comprising a center ring and a mid-flexure structure disposed between the first support structure and the second support structure. The center ring is adapted to provide a reactionary force to bending forces on the first and second coil sections and the mid-flexure structure is adapted to provide a substantially constant contact force with the first and second coil sections during expansion when the first and second coil sections are energized.

In accordance with another representative embodiment, a magnetic resonance imaging (MRI) device, comprises: an electrically superconductive coil having a first and second coil sections, which are separated and spaced apart from each other; a first support structure and a second support structure a disposed to support the first and second coil sections, wherein the first and second support structures are configured to maintain relative axial positions of the first and second coil sections to be fixed when the first and second coil sections are energized and de-energized, and to allow each of the first and second coil sections to expand radially during ramp energization; and a third support structure comprising a center ring and a mid-flexure structure disposed between the first support structure and the second support structure. The center ring is adapted to provide a reactionary force to bending forces on the first and second coil sections and the mid-flexure structure is adapted to provide a substantially constant contact force with the first and second coil sections during expansion when the first and second coil sections are energized.

### BRIEF DESCRIPTION OF THE DRAWINGS

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.
Fig. 1 is a perspective view of a magnetic resonance imaging (MRI) system in accordance with a representative embodiment.
Fig. 2 is a simplified block diagram of a superconducting magnet system which may be employed in an MRI apparatus according to a representative embodiment.
Fig. 3A is a perspective view of a superconducting apparatus in accordance with a representative embodiment.
Fig. 3B is an enlarged view of a portion of the superconducting apparatus of Fig. 3A.
Fig. 3C is a top view of a portion of the superconducting apparatus of Fig. 3A.
Fig. 3D a perspective view of a third support structure in accordance with a representative embodiment.
Fig. 3E is a side view of the third support structure including a center shoe in accordance with a representative embodiment.
Fig. 3F is a cross-sectional view of the third support structure of Fig. 3D along the line 3F-3F.
Fig. 3G is a cross-sectional view of the third support structure including the center shoe in accordance with a representative embodiment.
Fig. 4A is a perspective view of a superconducting apparatus 400 in accordance with a representative embodiment.
Fig. 4B is a cross-sectional view showing the center shoe between first and second superconducting coils in accordance with a representative embodiment.

### DETAILED DESCRIPTION

In the following detailed description, for the purposes of explanation and not limitation, representative embodiments disclosing specific details are set forth in order to provide a thorough understanding of embodiments according to the present teachings. However, other embodiments consistent with the present disclosure that depart from specific details disclosed herein remain within the scope of the appended claims. Descriptions of known systems, devices, materials, methods of operation and methods of manufacture may be omitted so as to avoid obscuring the description of the representative embodiments. Nonetheless, systems, devices, materials and methods that are within the purview of one of ordinary skill in the art are within the scope of the present teachings and may be used in accordance with the representative embodiments. It is to be understood that the terminology used herein is for purposes of describing particular embodiments only and is not intended to be limiting. Definitions and explanations for terms herein are in addition to the technical and scientific meanings of the terms as commonly understood and accepted in the technical field of the present teachings.

It will be understood that, although the terms first, second, third etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

As used in the specification and appended claims, the singular forms of terms 'a', 'an' and 'the' are intended to include both singular and plural forms, unless the context clearly dictates otherwise. Additionally, the terms "comprises," and/or "comprising," and/or similar terms when used in this specification, specify the presence of stated features, elements, and/or components, but do not preclude the presence or addition of one or more other features, elements, components, and/or groups thereof. As used herein, the term "and/or" includes any and all combinations of one or more of the associated listed items.

Unless otherwise noted, when an element or component is said to be "connected to", "coupled to", or "adjacent to" another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" or "immediately adjacent" to another element or component, this encompasses only cases where the two elements or components are connected or disposed immediately adjacent to each other without any intermediate or intervening elements or components.

Unless otherwise noted, when something is said to have approximately a certain value, then it means that it is within 10% of that value. As used herein, "substantially removes heat" means approximately 0.5W to approximately 2W for a superconducting magnet at 4K and approximately 1W to approximately 5W for a superconducting magnet at 20K.

As described herein in connection with various representative embodiments, the present teachings relate to a structure adapted for use in an MR apparatus that provides a structure comprising brackets that extend around the superconducting coils to provide structural support and comprise two different support structures. Certain support structures (e.g., first and second support structures described more fully below) are disposed along the length of the MR magnet, and other support structures (e.g., third support structures described more fully below) are disposed substantially orthogonally to the first and second support structures and make contact between the first and second support structures.

As described more fully below, the support structures of the representative embodiments are adapted to reduce the change in contact force between superconducting coils and a magnet spaceframe structure comprised of support structures described more fully below. This reduction in the contact force beneficially decreases the risk of relative motion between the superconducting coils and the spaceframe. Specifically, the support structures of the present teachings are adapted to balance comparatively large forces (e.g., ≥ 4.5·10⁶ kg (≥10⁷ lbs. )) created by the magnetic fields, while maintaining the position of those superconducting coils within acceptable limits. As can be appreciated by one of ordinary skill in the art, positioning of the superconducting coils may be required with a precision of fractions of a millimeter to provide the magnetic field accuracy needed for acceptable MR image quality. Stated somewhat differently, the support structures of the representative embodiments are adapted to substantially avoid locating the radial position of the superconducting coils with too high of a contact force. As will be appreciated by one of ordinary skill in the art, comparatively large localized coil contact forces can impact the coil shape and thereby impact the uniformity of the generated magnetic field. As such, the support structures are provided to balance magnitude of the forces on the superconducting coils to an acceptable degree. In addition, the support structures of the representative embodiments provide a statically determinate coil positioning, so that when ramping up proceeds from no current to full field, coils move and the support structures move the coils.

Moreover, the support structures of the various representative embodiments provide substantially continuous contact between the spaceframe structure and reduced gaps between the spaceframe structure and the superconducting coils to foster improved ramp up repeatability. As will be appreciated by one of ordinary skill in the art, the superconducting coils may be in slightly different positions from resulting from ramping up, ramping down, and ramping up again. Such movement may impact the uniformity of the magnetic field. As such, by the present teachings this relative motion, which is a cause of superconducting coil loss of field during ramping of magnetic field, is beneficially reduced. Among other benefits, the support structures of the present teachings maintain a positive superconducting coil contact force between the superconducting coils, and the spaceframe structure during the manufacturing tolerance cases of both the structure and the coils. Thereby, the coils do not substantially shift position from one ramping up to the next. Notably, in one embodiment the third support structure comprises a combined center-ring/mid-flexure third support structure is provided that provides a more cost-effective way to both react the hoop loads of the coil structure and also structurally mount the magnet center coils.

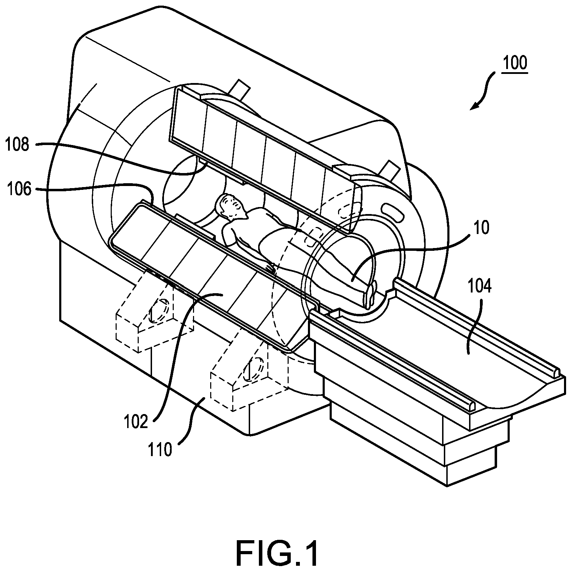

Fig. 1 is a perspective view of a magnetic resonance imaging (MRI) device 100 of a representative embodiment 100. The MRI device 100 comprises a superconducting magnet apparatus 102; a patient table 104 configured to hold a patient 10; electrically superconducting coils 106 configured to at least partially surround at least a portion of patient 10 for which MRI device 100 generates an image; a radio frequency coil 108 configured to apply a radio frequency signal to at least the portion of patient 10 which is being imaged, and to alter the alignment of the magnetic field. The general operation of an MRI device is known and many aspects of the MRI device are not repeated herein.

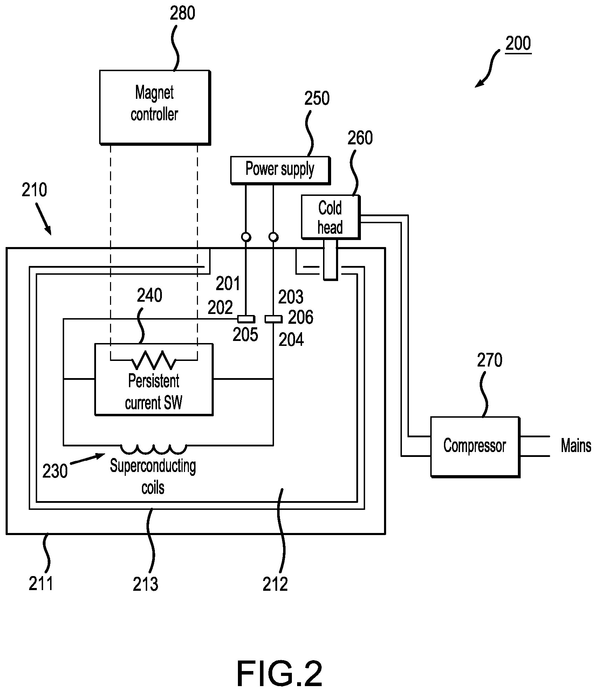

Fig. 2 is a simplified block diagram of a superconducting magnet system 200 which may be employed in an MRI apparatus, such as MRI device 100. In particular, superconducting magnet system 200 may be one embodiment of the superconducting magnet apparatus 102 in MRI device 100. It should be understood that, in general, superconducting magnet system 200 may include many other components which are not illustrated in Fig. 2. Some components have been omitted from Fig. 2 for clarity of illustration, and so as not to obscure aspects of the present invention to be discussed below.

Superconducting magnet system 200 includes a cryostat 210 having an enclosure, or outer vacuum container, 211 and a thermal shield 213 disposed within outer vacuum container 211 and a helium tank 212.

Superconducting magnet system 200 includes one or more electrically conductive coil(s) 230 and a persistent current switch 240 disposed within helium tank of cryostat 210, and an external power supply 250 disposed outside of (external to) cryostat 210. Superconducting magnet system 200 further includes a cold head 260 driven by a compressor 270 to recondense helium from helium tank 212. Superconducting magnet system 200 further includes a magnet controller 280 which may control various operations of superconducting magnet system 200.

Superconducting magnet system 200 further includes first and second electrically conductive leads 201 and 202 and third and fourth electrically conductive leads 203 and 204. First and second electrically conductive leads 201 and 202 are connected to each other at an electrical contact 205, and third and fourth electrically conductive leads 203 and 204 are connected to each other at an electrical contact 206. First electrically conductive lead 201 is connected to external power supply 250 via a switch (not shown). Third electrically conductive lead 203 is also connected to external power supply 250. Second and fourth electrically conductive leads 202 and 204 are connected to opposite ends of electrically conductive coil(s) 230.

In the depicted representative embodiment, the superconducting magnet system 200 is a helium bath type system. It is emphasized the superconducting magnet system 200 is merely illustrative, and other systems are contemplated. In some embodiments, helium tank 212 may contain a relatively small amount of cryogenic fluid compared to helium volumes in typical helium bath type systems, for example 50 to 100 liters (or less) of liquid helium. For example, the cooling of the superconducting magnet coils may be carried out using BlueSeal^{™} structures commercially available from Koninklijke Philips, N.V. As is known, BlueSeal structures are an alternative to bath cooling in which cooling may be done using conduction and convective cooling using heat pipes or thermosiphons. Here, a cooling medium like helium is used to transport heat and supply some thermal mass. The cooling material is typically enclosed and guided in tubular structures (not shown), from the refrigerator to the regions that need to be cooled. Gravity and appropriate layout enable circulation of the refrigerant. As described more fully below, in certain representative embodiments, a third support structure (not shown in Fig. 2) is provided to sealed magnetic resonance apparatuses (e.g., blue seal) comprising superconducting coils and a spaceframe structure comprising first and second support structures. As will be appreciated by one of ordinary skill in the art, these sealed magnetic resonance apparatuses which may be more susceptible to quenching loss of field due to relative motion between superconducting coils and the first and second support structures of the spaceframe. Notably, the various support structures of the representative embodiments are not limited to use in sealed magnetic resonance support structures, but rather are contemplated for use in other magnetic resonance apparatuses that may benefit from the reaction forces of the third support structures described in connection with various representative embodiments herein.

A persistent current switch 240 is disposed within helium tank 212 and may comprise a piece of superconductor wire connected across opposite ends of electrically conductive coil(s) 230 via second and fourth electrically conductive leads 202 and 204, attached to a small heater.

Superconducting magnet system 200 may have one or more sensors (not shown in FIG. 2) for measuring various operating parameters, such as temperatures, at various locations, levels of cryogenic fluid (e.g., liquid helium), whether components such as compressor 270 are properly operating, whether the power has been lost, for example due to an electrical power outage, etc. Each sensor may be connected to magnet controller 280 and supply a corresponding sensor signal to magnet controller 280.

A magnet controller 280 is provided and may comprise a processor and memory, including a tangible, non-transitory computer readable medium such as a nonvolatile memory and volatile memory. The nonvolatile memory may store programming code or instructions (software) for causing the processor to execute one or more algorithms for controlling operations of superconducting magnet system 200. In some embodiments, first and third electrically conductive leads 201 and 203 each may be retractable.

During a startup operation of superconducting magnet system 200, retractable first and third electrically conductive leads 201 and 203 are inserted into helium tank 212 and the wire in persistent current switch 240 is heated above its transition temperature so that it becomes resistive. In some embodiments, first and third electrically conductive leads 201 and 203 may each have a protruding pin at an end thereof which may be received and coupled into a socket provided in each of electrical contacts 205 and 206.

Electrically superconductive coil(s) 230 is/are initially energized by external power supply 250 passing a current through electrically conductive coil(s) 230. Since the wire in persistent current switch 240 is being heated during the startup operation, its resistance is substantially greater than that of electrically conductive coil(s) 230, so the current from the external power supply passes through electrically conductive coil 230.

For transitioning to operation in persistent mode, the current through electrically superconductive coil(s) 230 is adjusted until the desired magnetic field is obtained, then the heater in persistent current switch 240 is turned off. After the heater is turned off, the superconductor wire in persistent current switch 240 cools to its superconducting temperature, short-circuiting electrically superconductive coil(s) 230. The current in the power supply is ramped down and first and third electrically conductive leads 201 and 203 are retracted from helium tank 212.

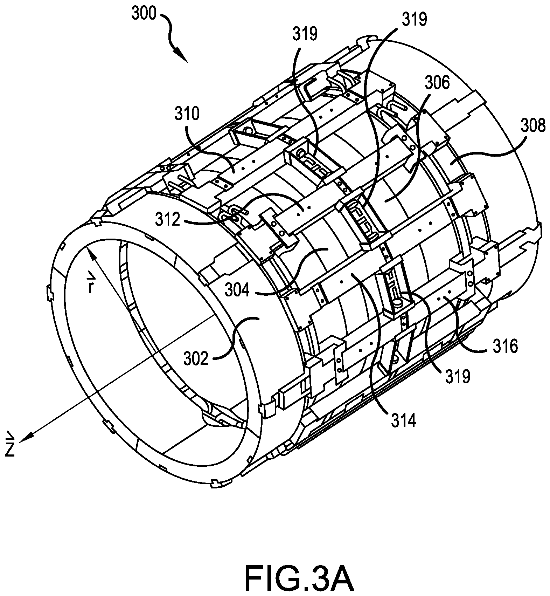

Fig. 3A is a perspective view of a superconducting apparatus 300 in accordance with a representative embodiment. As will become clearer as the present description continues, the superconducting apparatus 300 is adapted to be implemented in an MRI device, such MRI device 100.

The superconducting apparatus 300 comprises a first superconducting coil 302, a second superconducting coil 304, a third superconducting coil 306 and a fourth superconducting coil 308. As will be appreciated, each of the superconducting coils comprises windings comprising a superconducting material. Moreover, the use of four superconducting coils in the superconducting apparatus 300 is merely illustrative and is used to provide an understanding of components of the superconducting apparatus 300. As such, the superconducting apparatus 300 may comprise more or fewer superconducting coils than are shown. The superconducting coils may be main coils and/or shield coils, with the main coils adapted to generate the main magnetic field and the shield coils adapted to shield the MRI device from stray fields often generated by gradient coils of the MRI device.

The superconducting apparatus 300 also comprises first support structure 310, a second support structure 312, a fourth support structure 314, and a fifth support structure 316. Further details of the first, second, fourth, and fifth support structures 310, 312, 314 and 316 may be found in the above-incorporated U.S. Patent 10,365,338 to Jonas, et al.

A third support structure 319 is disposed between each of the first, second, fourth and fifth support structures 310, 312, 314 and 316 and orthogonally thereto. The first-fifth support structures 312-319 (and additional similar support structures not shown) may be referred to herein as the spaceframe structure or simply spaceframe. Finally, the number of support structures depicted in Fig. 3A is merely illustrative, and more or fewer support structures are contemplated.

The forces resulting during ramping up and persistent modes of operation of the first-fourth superconducting coils 302-308 are radially outward along the r-axis (radius) and perpendicular to the center or z-axis (longitudinal axis) of the coordinate system shown. Contact is maintained between the superconducting coils and the spaceframe structure to reduce the relative movement of the superconducting coils when energized. As described more fully below, this contact prevents unacceptable deformation of the shape of the superconducting coils when energized/energizing and thereby the superconducting coils are maintained in a desired configuration within acceptable limits. Beneficially, by maintaining the superconducting coils in a desired configuration by maintaining this contact, improvements in the magnetic field uniformity generated by the superconducting coils are realized. Notably, as will be appreciated by one of ordinary skill in the art, a minimum degree of magnetic field uniformity is needed for the MRI device to effectively function.

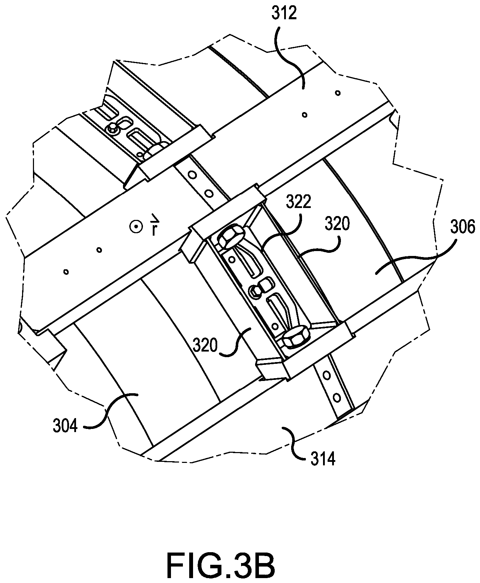

Fig. 3B is an enlarged view of a portion of the superconducting apparatus of Fig. 3A. Various aspects and details of the portion of the superconducting apparatus described in connection with Fig. 3A may be common to representative embodiments of Fig. 3B. Such common aspects and details may not be repeated to avoid obscuring the presently described representative embodiments.

Among other details, Fig. 3B provides further details of the third support structure 319. The third support structure 319 is disposed between the second support structure 312 and the fourth support structure 314 comprises center ring 320 disposed on opposing sides of a mid-flexure structure 322, and between the second superconducting coil 304 and the third superconducting coil 306. As described more fully below, the center ring 320, with other words mid-flexure stiffener, may comprise all four "walls" of which three are shown in Fig. 3B, provides a reactionary force to the radially outward (parallel to the r-axis of Fig. 3B) forces generated during ramping up and persistent modes of operation of the superconducting coils. These radially outward forces, if unchecked, would result in unacceptable deformation of the superconducting coils, and as a result, an unacceptable lack of uniformity of the resultant magnetic field.

The mid-flexure 322 functions as a leaf spring. As described more fully below, the mid-flexure 322 is adapted to maintain the contact forces between the spaceframe and the superconducting coils.

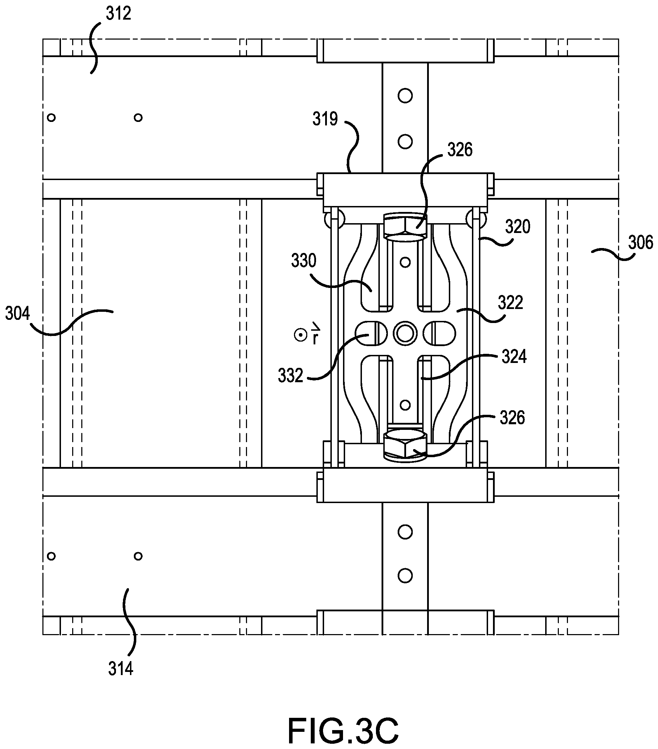

Fig. 3C is a top view of a portion of the superconducting apparatus of Fig. 3A. Various aspects and details of the portion of the superconducting apparatus described in connection with Fig. 3A may be common to representative embodiments of Fig. 3B. Such common aspects and details may not be repeated to avoid obscuring the presently described representative embodiments.

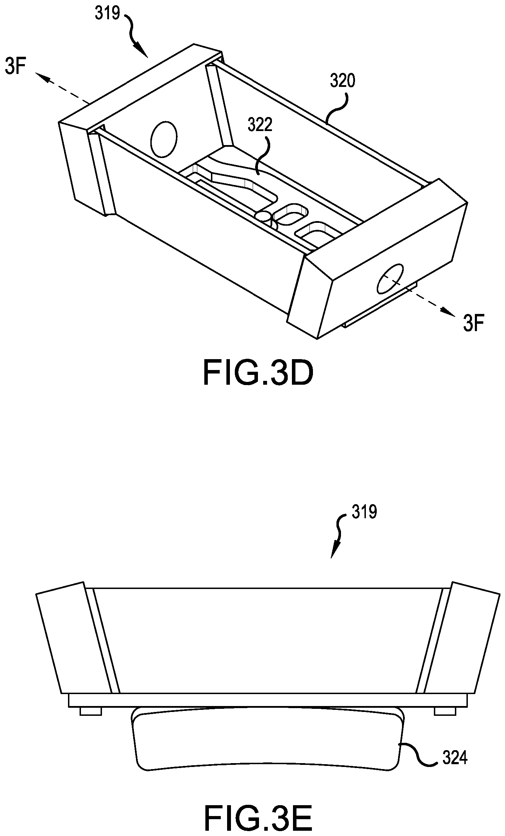

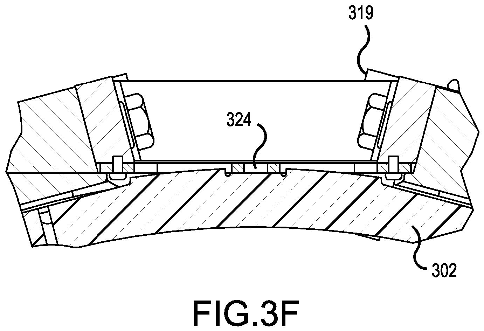

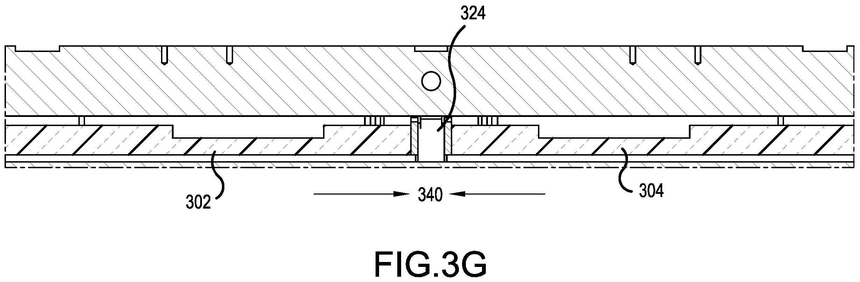

As shown, the third support structure 319 in the depicted representative embodiment is between the fourth support structure 314 and the second support structure 312. As noted above and shown in Fig. 3A for example, other third support structures 319 (not shown in Fig. 3C) are provided between each of first, second, fourth and fifth support structures 310, 312, 314 and 316 and oriented orthogonally thereto. As described more fully below, the center ring 320 is adapted to react to the bending forces of the first, second, fourth and fifth support structures 310, 314, 316 and mid-flexure 322 in the radial direction, and forces between the superconducting coils and the support structures in the axial direction of the coordinate axis shown in Fig. 3; and the mid-flexure 322 is adapted to maintain a substantially constant force between the first-fourth superconducting coils 302-308 and the fourth support structure 314 and the second support structure 312. Notably, in accordance with a representative embodiment, "substantially constant force" means the force has a magnitude great enough to maintain the second and third superconducting coils 304, 306 located coaxially with first-fourth superconducting coils 302-308 within approximately 0.5 mm, while maintaining the radial deformation of first-fourth superconducting coils 302-308 less than approximately 0.2 mm. Finally, a center shoe 324 is attached to the third support structure 319. As described more fully below, the center shoe 324 is arranged so the relative motion between the center shoe 324 and the second and the third superconducting coils 304, 306, if any, is maintained at an acceptable amount. By way of illustration the relative motion should be maintained to less than approximately 0.1 mm, with the less relative motion the better. Beneficially, by minimizing or eliminating the relative motion between the center shoe 324 and the second and third superconducting coils 304, 306, friction between third support structure 319 and the second and fourth support structures 312, 314 is kept at an acceptable amount. By way of illustration the relative motion should be maintained to less than approximately 0.1 mm, if not eliminated. As will be appreciated by one of ordinary skill in the art, friction creates heat, which can impact the function of the superconducting coils by reducing the superconduction of current, thereby adversely impacting the magnet field generated by the superconducting coils.

The center ring 320 comprises a plurality of walls that surround the mid-flexure 322. The center ring 320 is welded to the mid-flexure 322 and is coupled to the second and fourth support structures 312, 314 using fasteners 326 (e.g., bolts) as shown. The center ring 320 comprises a material having suitable mechanical strength to provide an adequate reactionary force to at least the second and fourth support structures 312, 314, which are in-turn acted upon by the expansion of the second and third superconducting coils 304, 306 during ramping up and persistent mode operation. Illustratively, the center ring 320 may be made of stainless steel, aluminum or titanium having dimensions suitable to effect the needed reactionary forces thereon. By selection of the appropriate material and dimensions, the center ring 320 reacts to the bending forces on the support structure comprising the spaceframe structure. Specifically, by selection of the appropriate materials and dimensions, the stiffness of this center ring is sized such that the bending of the spaceframe structure substantially matches the expansion of the superconducting coils during ramp up and persistent mode operation. As used herein in this context, where "substantially matches" as used herein means the free expansion of the superconducting coils due to energization moves at the center contact points with the center coils within approximately 0.1mm. The mid-flexure 322 comprise openings 330, 332 adapted to provide the function of a leaf spring. The mid-flexure 322 is pre-loaded against the center ring 320 and comprises a comparatively flexible ("soft") material such as aluminum, titanium, titanium alloy, brass, and magnesium alloy in order to provide flexibility so the forces between the support structures of the spaceframe are maintained at a substantially constant level (e.g., the contact forces do not vary more than approximately 500 N.

As alluded to above, the mid-flexure is also tuned to provide the noted substantially constant force between the superconducting coils and the components of the spaceframe as well. Specifically, the various elements of the mid-flexure have dimensions suitable to provide this substantially constant force during ramping up and persistent operation. In accordance with a representative embodiment, the tuning comprises iterative adjustment of the cross sectional area of the various elements comprising the mid-flexure 322 so that when the coils are energized and expand, the various support structures of the space frame are expanding at substantially the same rate as the expansion of the coils. Beneficially, this substantially identical expansion consistently positions the superconducting coils, which improves uniformity of the magnetic field.

Among other benefits, this tuning of the mid-flexure 322 for a particular magnetic resonance apparatus comprising superconducting coils during manufacture of the magnetic resonance apparatus. As such, during production, this tuned mid-flexure structure is adapted for use in all similar magnetic resonance apparatuses without further adjustment. As will be appreciated, because the mid-flexure 322 is suitably tuned for each magnetic resonance structure of a particular production run, further adjustment of the various components of the spaceframe is not required once the production of the magnetic resonance structures is complete. By contrast, in other known systems, adjustment of the spaceframe structures after production by trial and error are required. Not only does this adjustment complicate the production of known magnetic resonances apparatuses and thereby increase the cost of production, but also the substantially constant reactionary forces are less than optimal, if even acceptable.

Fig. 3D is another perspective view of the third support structure 319 in accordance with a representative embodiment. Fig. 3E provides a better view of the center shoe 324, which is attached to the mid-flexure 322, while Fig. 3G shoes the third support structure 319 including the center shoe 324 disposed over a superconducting coil (e.g., first superconducting coil 302). Fig. 3F is a cross-sectional view of the third support structure 319 of Fig. 3D along the line 3F-3F.

Turning to Figs. 3D, 3E and 3F, the center shoe 324 is shown disposed beneath the third support structure 319. Notably, in Fig. 3F, the center shoe 324 is shown in cross-section and disposed over, for example, the first superconducting coil 302. Illustratively, the center shoe 324 comprises a stainless steel, aluminum, or any suitable structural material, and has dimensions capable of withstanding the comparatively large forces during energizing and operation of the superconducting coils.

Turning to Fig. 3G, the center shoe 324 is shown between the first and second superconducting coils 302, 304. The center shoe 324 is connected (e.g., bolted) directly to the mid-flexure 322, and thus is adapted to move with the coils. As noted above, the first and second superconducting coils generate significant forces 340 during energizing of the superconducting coils. The center shoe 324 is disposed between the first and second superconducting coils 302, 304, and moves with the first and second superconducting coils to prevent any relative motion between them. As will be appreciated, relative motion between the first and second superconducting coils 302, 304 (and, or course other superconducting coils of the magnetic resonance apparatus in which they are deployed), may cause friction between the first and second superconducting coils 302, 304. This friction creates heat, which can raise the temperature of the first and second superconducting coils 302, 304 unacceptably. Notably, the superconducting coils are maintained at a comparatively low temperature (e.g., 4 K) to function properly. Moreover, at such low temperatures, the various components of the spaceframe have a comparatively low specific heat. As such, heat caused by this friction can raise the temperature in the first and second superconducting coils 302, 304 and compromise the superconduction of current. Ultimately, this results in the undesirable loss of the magnetic field generated by the first and second superconducting coils 302, 304. Beneficially, therefore, the center shoe 324, in addition to providing additional structure to the spaceframe, also prevents unacceptable heating caused by relative friction between the first and second superconducting coils 302, 304.

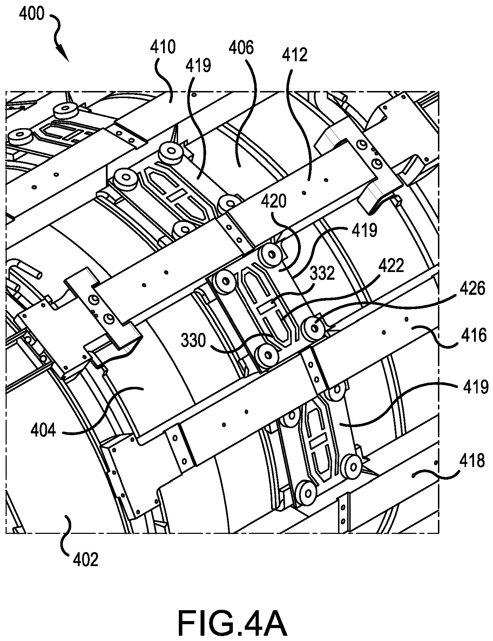

In the representative embodiments of Figs. 3A-3G, the center ring 320 design is separate piece from the mid-flexure 322 and comprises welded or cast structural components. The mid-flexure 322 and center ring 320 are bolted with it into the other support structures of the space frame. In the representative embodiments described in connection with Figs. 4A-4B described below, the third support structure 419 comprises a mid-flexure 422 that provides the functionality of the mid-flexure 322 and the center ring 320 in a single piece of sheet or plate of material. The third support structure 419 may, for example, be stamped or otherwise formed based on the various desired parameters of the third support structure 319 to provide the tuned element, needed structural support and forces described above. Providing the support structure in this way beneficially reduces the cost of the subassembly and provides a substantially identical functionality. Various aspects and details of the portion of mid-flexure 322, center ring 320 and center shoe described above in connection with Figs. 3A-3G may be common to representative embodiments of Figs. 4A-4B. Such common aspects and details may not be repeated to avoid obscuring the presently described representative embodiments.

Fig. 4A is a perspective view of a superconducting apparatus 400 in accordance with a representative embodiment. As will become clearer as the present description continues, the superconducting apparatus 400 is adapted to be implemented in an MRI device, such MRI device 100.

The superconducting apparatus 400 comprises a first superconducting coil 402, a second superconducting coil 404, a third superconducting coil 406 and a fourth superconducting coil (not shown). As will be appreciated, each of the superconducting coils comprises windings comprising a superconducting material. Moreover, the use of four superconducting coils in the superconducting apparatus 400 is merely illustrative and is used to provide an understanding of components of the superconducting apparatus 400. As such, the superconducting apparatus 400 may comprise more or fewer superconducting coils than are shown. The superconducting coils may be main coils and/or shield coils, with the main coils adapted to generate the main magnetic field and the shield coils adapted to shield the MRI device from stray fields often generated by gradient coils of the MRI device.

The superconducting apparatus 400 also comprises first support structure 410, a second support structure 412, a fourth support structure 416, and a fifth support structure 418. Further details of the first, second, fourth, and fifth support structures 410, 412, 416 and 418 may be found in the above-incorporated U.S. Patent 10,365,338 to Jonas, et al.

A third support structure 419 is disposed between each of the first, second, fourth and fifth support structures 410, 412, 416 and 418 and oriented orthogonally thereto. Notably, it is contemplated that as many as three of the third support structures 419 may be disposed between each of the first, second, fourth and fifth support structures 410, 412, 416 and 418 and oriented orthogonally thereto. The first-fifth support structures 410-419 (and additional similar support structures not shown) may be referred to herein as the spaceframe structure or simply spaceframe. Finally, the number of support structures depicted in Fig. 4A is merely illustrative, and more or fewer support structures are contemplated.

Notably, the forces resulting in ramping up and persistent modes of operation of the first-fourth superconducting coils are radially outward along the r-axis and perpendicular to the center or z-axis of the coordinate system shown. Contact is maintained between the superconducting coils and the spaceframe structure to reduce the relative movement of the superconducting coils when energized. As described more fully below, this contact prevents unacceptable deformation of the shape of the superconducting coils when energized/energizing and thereby the superconducting coils are maintained in a desired configuration within acceptable limits. Beneficially, by maintaining the superconducting coils in a desired configuration by maintaining this contact, improvements in the magnetic field uniformity generated by the superconducting coils are realized. Just by way of illustration and not limitation, the uniformity of the magnetic field of the superconducting apparatus 400 is on the order of approximately 12 PPM to approximately 30 PPM.

As will be appreciated from a review of Figs. 3C and 4A, the basic structure of the third support structure 419 is very similar to the third support structure 319. Specifically, the third support structure 419 also comprises mid-flexure stiffeners 420 disposed on opposing sides of a mid-flexure 422. Notably, however, the mid-flexure stiffeners 420 and mid-flexure 422 are provided from a single piece of material as noted above. The mid-flexure stiffeners 420 also substantially coplanar with the mid-flexure and coupled to the second and fourth support structures 412, 416 using fasteners 426 (e.g., bolts) as shown. The mid-flexure stiffeners 420 comprises a material having suitable mechanical strength to provide an adequate reactionary force to at least the second and fourth support structures 412, 416, which are in-turn acted upon by the expansion of the second and third superconducting coils 404, 406 during ramping up and persistent mode operation. In accordance with a representative embodiment, the mid-flexure stiffeners 420 are made of aluminum, stainless steel and titanium alloys and have a thickness in the range of approximately 3 mm to approximately 15 mm. By selection of the appropriate material and dimensions, the mid-flexure stiffener 420 reacts to the bending forces on the support structure comprising the spaceframe structure. In accordance with a representative embodiment, the mid-flexure stiffener 420 may comprise aluminum, stainless steel or titanium and have a thickness of approximately 3 mm to approximately 15 mm. Beneficially, by selection of the appropriate materials and dimensions, the stiffness of this mid-flexure stiffener 420 is sized such that the bending of the spaceframe structure substantially matches the expansion of the superconducting coils during ramp up and persistent mode operation. As used herein in this context, where "substantially matches" as used herein means the free expansion of the superconducting coils due to energization moves at the center contact points with the center coils within approximately 0.1 mm.

The mid-flexure 422 comprise openings 330, 332 adapted to provide the function of a leaf spring. The mid-flexure 422 is pre-loaded against the mid-flexure stiffener 420 and comprises a comparatively flexible ("soft") material such as aluminum, titanium or stainless steel alloys in order to provide flexibility so the forces between the support structures of the spaceframe are maintained at a substantially constant level. Notably, in this context, "substantially constant level" means the forces are adequate to react to gravity loads on the superconducting coils in order to position the superconducting coils accurately.

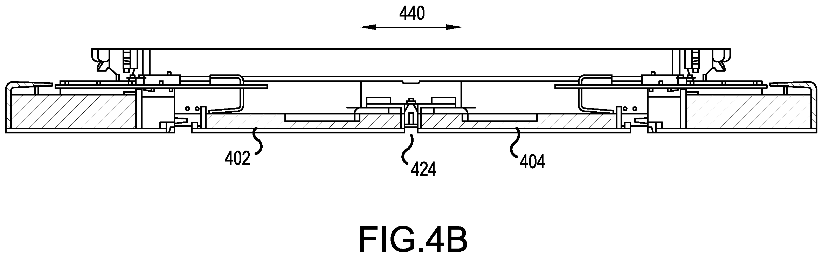

Turning to Fig. 4B, the center shoe 424 is shown between the first and second superconducting coils 402, 404. The center shoe 424 is connected (e.g., bolted) to the mid-flexure 422 and accordingly is adapted to move with the superconducting coils. As noted above, the first and second superconducting coils generate significant forces 440 during expansion. The center shoe 424 is disposed between the first and second superconducting coils 402, 404, and moves with the first and second superconducting coils to prevent any relative motion between them. By way of illustration the relative motion should be maintained to less than approximately 0.1 mm. As will be appreciated, relative motion between the first and second superconducting coils 402, 404 (and, of course other superconducting coils of the magnetic resonance apparatus in which they are deployed), may cause friction between the first and second superconducting coils 402, 404. This friction creates heat, which can raise the temperature of the first and second superconducting coils 402, 404 unacceptably. Notably, the superconducting coils are maintained at a comparatively low temperature (e.g., 4 K) to function properly. Moreover, at such low temperatures, the various components of the spaceframe have a comparatively low specific heat. As such, heat caused by this friction can raise the temperature in the first and second superconducting coils 402, 404 and compromise the superconduction of current. Ultimately, this results in the formation of unacceptable magnetic fields that can deleteriously impact quality (e.g., uniformity and strength) of the magnetic field generated by the first and second superconducting coils 402, 404. Beneficially, therefore, the center shoe 424, in addition to providing additional structure to the spaceframe, also prevents unacceptable heating caused by relative friction between the first and second superconducting coils 402, 404.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

The Abstract of the Disclosure is provided to comply with 37 C.F.R. §1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The preceding description of the disclosed embodiments is provided to enable any person skilled in the art to practice the concepts described in the present disclosure. As such, the above disclosed subject matter is to be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure is to be determined by the broadest permissible interpretation of the following claims and their equivalents and shall not be restricted or limited by the foregoing detailed description.

## Claims

1. A superconducting apparatus (102), comprising:
an electrically superconductive coil having a first and second coil sections (304, 306), which are separated and spaced apart from each other;
a first support structure (312) and a second support structure (314) disposed to support the first and second coil sections, wherein the first and second support structures are configured to maintain relative axial positions of the first and second coil sections to be fixed when the first and second coil sections are energized and de-energized, and to allow each of the first and second coil sections to expand radially during ramp energization; and
a third support structure (319) comprising a mid-flexure stiffener (320) and a mid-flexure structure (322) disposed between the first support structure and the second support structure, wherein the mid-flexure stiffener is adapted to provide a reactionary force to bending forces on the first and second coil sections and the mid-flexure structure is adapted to provide a substantially constant contact force with the first and second coil sections during expansion when the first and second coil sections are energized.

2. The superconducting apparatus of claim 1, wherein the third support structure further comprises a center shoe disposed between the first and second coil sections, the center shoe being adapted to limit relative motion between the center shoe and the first and second coil sections during magnetic field ramping.

3. The superconducting apparatus of claim 1 or 2, wherein the mid-flexure structure is preloaded against the first and second coil sections, and has a stiffness that is less than a stiffness of the first and second support structures.

4. The superconducting apparatus of any of the preceding claims, wherein the first and second support structures comprise stainless steel or aluminum and the mid-flexure structure comprises aluminum or a titanium alloy.

5. The superconducting apparatus of any of the preceding claims, wherein the mid-flexure stiffener is a center ring.

6. The superconducting apparatus of claim 5, wherein the center ring is oriented at approximately 90° relative to the mid-flexure structure.

7. The superconducting apparatus of any of the preceding claims, wherein the mid-flexure stiffener is substantially co-planar with the mid-flexure structure.

8. The superconducting apparatus of any of the preceding claims, wherein the mid-flexure stiffener and the mid-flexure structure are welded to the first and second support structures.

9. The superconducting apparatus of any of the preceding claims, wherein the mid-flexure stiffener and the mid-flexure structure are bolted to the first and second support structures.

10. The superconducting apparatus of any of the preceding claims, wherein the mid-flexure structure comprises openings.

11. The superconducting apparatus of any of the preceding claims, wherein the mid-flexure structure comprises openings.

12. The superconducting apparatus of any of the preceding claims, wherein a stiffness of the mid-flexure stiffener is selected such that bending of the first and second support structures substantially match the expansion of the first and second coil sections during ramp up.

13. The superconducting apparatus of any of the preceding claims, wherein the mid-flexure structure functions as a leaf spring.

14. A magnetic resonance imaging device, comprising a superconducting apparatus according to any of the claims 1 to 13.
